# EUROPEAN PATENT APPLICATION

(11) **EP 4 145 540 A1**
(43) Date of publication of application: **08.03.2023**
(21) Application number: 21195061.3
(22) Date of filing: 06.09.2021
(51) Int. Cl.: H01L 31/0352, G01S 7/00, H01L 31/107, H01L 31/18

(54) **TIME OF FLIGHT SENSOR AND METHOD FOR FABRICATING A TIME OF FLIGHT SENSOR**

(71) Applicant: Infineon Technologies AG, 85579 Neubiberg (DE)
(72) Inventor: TADDIKEN, Hans, 81737 Muenchen (DE); OFFENBERG, Dirk, 01099 Dresden (DE); PINNAPA, Trinath Reddy, 01307 Dresden (DE); ROTHENHAEUSSER, Steffen, 01099 Dresden (DE)
(74) Representative: Lambsdorff & Lange Patentanwälte Partnerschaft mbB

(57) **Abstract**

A time of flight sensor comprises at least one pixel (100), comprising: an epitaxially-grown Ge-based photosensitive structure (110) comprising an upper portion (111) and a trunk portion (112), a Si-based photocurrent collecting structure (120), a dielectric material layer (130) arranged at least between the upper portion of the photosensitive structure and the photocurrent collecting structure, wherein the trunk portion of the photosensitive structure is arranged within an aperture (131) in the dielectric material layer, and at least one n-contact (140) configured to collect electrons of a photocurrent and at least one p-contact (150) configured to collect holes of the photocurrent, the at least one n-contact and p-contact arranged in the photocurrent collecting structure.

## Description

### TECHNICAL FIELD

This disclosure relates in general to a time of flight sensor, in particular a time of flight sensor wherein a pixel comprises a Ge-based photosensitive structure and a Si-based photocurrent collecting structure, as well as to a method for fabricating such a time of flight sensor.

### BACKGROUND

Time of flight sensors may use infrared light which is invisible to the human eye. However, at the typically used wavelength of about 900nm, Si as a detector material exhibits a poor light absorption coefficient. This makes it necessary to use Si absorbing structures of comparatively large thickness which reduces the accuracy of the sensor. Ge as detector material has a higher absorption coefficient in the 900nm range and it can also absorb photons at larger wavelength than Si, enabling the fabrication of time of flight sensors which operate at such larger wavelengths. Time of flight sensors comprising Si and Ge may advantageously combine the superior light absorption properties of Ge with the better mastered electrical properties of Si. However, there is still room to improve the measurement uncertainty of such sensors. Improved time of flight sensors as well as improved methods for fabricating time of flight sensors may help with solving these and other problems.

The problem on which the invention is based is solved by the features of the independent claims. Further advantageous examples are described in the dependent claims.

### SUMMARY

Various aspects pertain to a time of flight sensor, comprising: at least one pixel, comprising: an epitaxially-grown Ge-based photosensitive structure comprising an upper portion and a trunk portion, a Si-based photocurrent collecting structure, a dielectric material layer arranged at least between the upper portion of the photosensitive structure and the photocurrent collecting structure, wherein the trunk portion of the photosensitive structure is arranged within an aperture in the dielectric material layer, and at least one n-contact configured to collect electrons of a photocurrent and at least one p-contact configured to collect holes of the photocurrent, the at least one n-contact and p-contact arranged in the photocurrent collecting structure.

Various aspects pertain to a method for fabricating a time of flight sensor comprising at least one pixel, the method comprising: providing a Si-based photocurrent collecting structure, arranging a dielectric material layer on the photocurrent collecting structure, fabricating a aperture within the dielectric material layer, epitaxially growing a Ge-based photosensitive structure on the photocurrent collecting structure, starting in the aperture, the photosensitive structure comprising an upper portion and a trunk portion, wherein the trunk portion is arranged within the aperture and the upper portion is arranged above the dielectric material layer, and fabricating in the photocurrent collecting structure at least one n-contact configured to collect electrons of a photocurrent and at least one p-contact configured to collect holes of the photocurrent.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figure 1 shows a cross section of a time of flight sensor comprising at least one pixel with a Ge-based photosensitive structure and a Si-based photocurrent collecting structure.
Figure 2 shows a cross section of a further time of flight sensor, similar to the sensor of Fig. 1, wherein the photocurrent collecting structure comprises both an n-doped region and a p-doped region.
Figure 3 shows a top view of the time of flight sensor of Fig. 2, wherein the photosensitive structure and the dielectric material layer are omitted.
Figures 4A and 4B show a top view (Fig. 4A) and a cross section (Fig. 4B) of a further time of flight sensor, wherein the n-doped region and the p-doped region have a different arrangement than in the example shown in Fig. 2.
Figure 5 shows a further time of flight sensor, wherein the photosensitive structure comprises at least two trunk portions instead of a single trunk portion.
Figures 6A to 6E show the time of flight sensor of Fig. 2 in various stages of fabrication, according to an exemplary method for fabricating time of flight sensors.
Figure 7 is a flow chart of an exemplary method for fabricating time of flight sensors.

### DETAILED DESCRIPTION

In the following detailed description, directional terminology, such as "top", "bottom", "left", "right", "upper", "lower" etc., is used with reference to the orientation of the Figure(s) being described. Because components of the disclosure can be positioned in a number of different orientations, the directional terminology is used for purposes of illustration only.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted. Furthermore, to the extent that the terms "include", "have", "with" or other variants thereof are used in either the detailed description or the claims, such terms are intended to be inclusive in a manner similar to the term "comprise". Also, the term "exemplary" is merely meant as an example, rather than the best or optimal.

An efficient time of flight sensor may for example reduce material consumption, ohmic losses, chemical waste, ... and may thus enable energy and/or resource savings. Improved time of flight sensors, as well as improved methods for fabricating time of flight sensors, as specified in this description, may thus at least indirectly contribute to green technology solutions, i.e. climate-friendly solutions providing a mitigation of energy and/or resource use.

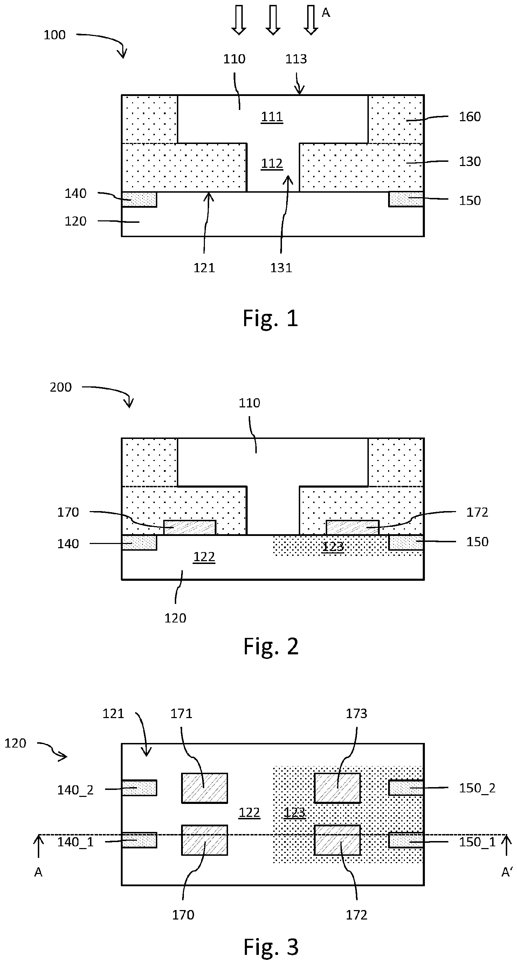

Figure 1 shows a pixel 100 of a time of flight sensor, the pixel 100 comprising a photosensitive structure 110, a photocurrent collecting structure 120, a dielectric material layer 130, at least one n-contact 140 and at least one p-contact 150. The time of flight sensor may comprise a single pixel 100 or it may comprise a plurality of pixels 100. The time of flight sensor may further comprise suitable evaluation circuitry for evaluating a signal detected by the at least one pixel 100. The time of flight sensor may in particular be an indirect time of flight sensor (iTOF sensor), wherein modulated light is emitted and the modulation shift in the returned light may be measured to calculate distance.

The photosensitive structure 110 is an epitaxially-grown structure which may comprise or consist of Ge. The photosensitive structure 110 may be arranged on an upper surface 121 of the photocurrent collecting structure 120. In particular, the photosensitive structure 110 may be epitaxially grown on the photocurrent collecting structure 120. The structure 110 is termed a "photosensitive" structure because it is a dedicated light absorption part of the pixel 110, wherein incoming photons, in particular infrared photons, are converted into electrons and holes (i.e. a photocurrent). The incoming photons are indicated by the arrows A in Fig. 1.

The photocurrent collecting structure 120 may comprise or consist of Si and it may e.g. be a structure epitaxially grown on bulk Si.

The photosensitive structure 110 comprises an upper portion 111 and a trunk portion 112. The upper portion 111 and the trunk portion 112 are integral with each other. In other words, the upper portion 111 and the trunk portion 112 are regions of a single contiguous photosensitive structure 110. The trunk portion 112 is arranged on the photocurrent collecting structure 120 and the upper portion 111 is arranged on the trunk portion 112. A cross section of the photosensitive structure 110 may essentially have a T-shape, as shown in Fig. 1.

The trunk portion 112 may for example have a lateral extension, measured parallel to the upper surface 121 of the photocurrent collecting structure 120, in the range of 100nm, 200nm, 300nm, 500nm, 800nm, 1µm, 1.5µm, 2µm, or more. The trunk portion 112 may for example have a vertical extension, measured perpendicular to the upper surface 121, in the range of 300nm, 500nm, 800nm, 1µm, 1.5µm, 2µm, or more. A lateral extension of the upper portion 111 may for example be about two times, three times, four times, ... the lateral extension of the trunk portion 112. The lateral extension of the upper portion 111 may be smaller than a lateral extension of the photocurrent collecting structure 120. A vertical extension of the upper portion 111 may for example be in the range of 300nm, 500nm, 800nm, 1µm, 1.5µm, 2µm, or more.

The dielectric material layer 130 is arranged at least between the upper portion 111 of the photosensitive structure 110 and the photocurrent collecting structure 120. Furthermore, the dielectric material layer 130 comprises an aperture 131, wherein the trunk portion 112 of the photosensitive structure 110 is arranged within the aperture 131. The trunk portion 112 may in particular completely fill the aperture 131.

The aperture 131 may for example have an aspect ratio in the range of 1:1 to 1:10, e.g. an aspect ratio of about 1:2, 1:4, 1:6, or 1:8. The aperture 131 may be used for aspect ratio trapping (ART) to prevent dislocations in the lattice from propagating to the upper portion 111 during epitaxial growth of the photosensitive structure 110.

According to an example, the pixel 100 may comprise a further dielectric material layer 160 arranged on the dielectric material layer 130 and laterally surrounding the upper portion 111 of the photosensitive structure 110. According to another example, the dielectric material layer 130 reaches to and laterally surrounds the upper portion 111.

The dielectric material layer 130 may comprise or consist of any suitable dielectric material, for example an oxide like silicon oxide. The further dielectric material layer 160 may comprise or consist of the same dielectric material or a different dielectric material as the dielectric material layer 130.

The at least one n-contact 140 is configured to collect electrons of a photocurrent and the at least one p-contact 150 is configured to collect holes of the photocurrent. The at least one n-contact 140 and the at least one p-contact 150 are arranged in the photocurrent collecting structure 120. The n-contact 140 and p-contact 150 may for example be arranged at the upper surface 121 of the photocurrent collecting structure 120. The n-contact 140 and p-contact 150 may comprise or consist of a suitable metallization structure (e.g. comprising or consisting of Al) and may be coupled to evaluation circuitry of the time of flight sensor (not shown in Fig. 1).

As shown in Fig. 1, the contacts 140, 150 for both charge carriers of the photocurrent (i.e. electrons and holes) are arranged in the (Si-based) photocurrent collecting structure 120. No contact for a charge carrier is arranged in the (Ge-based) photosensitive structure 110. This arrangement of the n-contact(s) 140 and p-contact(s) 150 may allow measuring the photocurrent using both electrons and holes. This in turn may reduce the measurement uncertainty Δ*z* of the pixel 100 because Δ*z* = 1/2·(Δ*zₑ* + Δ*zₕ*), wherein Δ*zₑ* and Δ*zₕ* are the measurement uncertainties based on the electron current and the hole current.

According to an example, the photosensitive structure 110 comprises p-doped Ge, the photocurrent collecting structure 120 essentially comprises n-doped Si and a comparatively small region with p-doped Si, and the at least one n-contact 140 is arranged in the n-doped Si and the at least one p-contact is arranged in the p-doped Si. According to another example, the doping scheme is reversed. Exemplary arrangements of the n-doped Si and p-doped Si are described further below.

The time of flight sensor may be configured such that an upper surface 113 of the photosensitive structure 110 points towards incoming light. The time of flight sensor may comprise protective layers or protective structures and/or a lens arranged over the upper surface 113.

Figure 2 shows a further pixel 200 of a time of flight sensor. The pixel 200 may be similar to or identical with the pixel 100.

The pixel 200 comprises all components described with respect to Fig. 1 and the photocurrent collecting structure 120 of pixel 200 also comprises an n-doped region 122 and a p-doped region 123. The at least one n-contact 140 is arranged in the n-doped region 122 and the at least one p-contact 150 is arranged in the p-doped region 123.

The n-doped region 122 is configured to conduct electrons of the photocurrent to the at least one n-contact 140 and the p-doped region 123 is configured to conduct holes of the photocurrent to the at least one p-contact 150. To this end, the n-doped region 122 and the p-doped region 123 are both in contact with the photosensitive structure 110. In particular, the n-doped region 122 and the p-doped region 123 may both be in contact with the trunk portion 112 of the photosensitive structure 110. In other words, a p-n junction within the photocurrent collecting structure 120 may be arranged vertically below the trunk portion 112 of the photosensitive structure 110.

As shown in Fig. 2, the n-doped region 122 and the p-doped region 123 may be laterally juxtaposed. The n-doped region 122 may additionally extend below the p-doped region 123 such that the p-doped region 123 only forms a comparatively thin channel within the photocurrent collecting structure 120. The p-doped region 123 may essentially be arranged at the upper surface 121 of the photocurrent collecting structure 120.

The pixel 200 may further comprise demodulation gates 170, 172 configured to direct electrons of the photocurrent to a particular n-contact 140 of a plurality of n-contacts, respectively holes of the photocurrent to a particular p-contact 150 of a plurality of p-contacts.

The demodulation gates 170, 172 may for example be arranged on the upper surface of the photocurrent collecting structure 120, next to the trunk portion 112 of the photosensitive structure 110. The demodulation gates 170, 172 may be controlled by suitable control circuitry of the time of flight sensor.

According to another example, instead of the doping scheme shown in Fig. 2, the detector for the holes of the photocurrent uses n-doped Si and a p-doped gate.

Figure 3 shows a top view of the pixel 200 according to a particular example. In Fig. 3 the photosensitive structure 110 and the dielectric material layer 130 are omitted in order to show the n-doped region 122 and the p-doped region 123 of the photocurrent collecting structure 120. Fig. 2 shows a cross section of the pixel 200 along the line A-A' in Fig. 3.

As shown in Fig. 3, the n-doped region 122 may surround the p-doped region 123 on three sides. It is however also possible that the whole right half of the upper side 121 is comprised of the p-doped region 123. The p-doped region 123 may essentially have any shape suitable for conducting holes of the photocurrent to the at least one p-contact 150.

In the example shown in Fig. 3, the pixel 200 comprises a first n-contact 140_1 and a second n-contact 140_2, a first p-contact 150_1 and a second p-contact 150_2, and a first, second, third and fourth demodulation gate 170, 171, 172, 173.

The first and second demodulation gates 170, 171 are configured to direct electrons of the photocurrent to either the first n-contact 140_1 or to the second n-contact 140_2. The third and fourth demodulation gates 172, 173 are configured to direct holes of the photocurrent to either the first p-contact 150_1 or the second p-contact 150_2. For example, the first and third demodulation gates 170, 172 may be operated exactly in sync with a light emitter of the time of flight sensor and the second and fourth demodulation gates 171, 173 may be operated exactly out of sync with the emitter. The phase shift of the received light and therefore a distance measurement can be calculated by comparing the amount of electrons and holes caught by the first n-contact 140_1 and p-contact 150_1 vs. the amount of electrons and holes caught by the second n-contact 140_2 and p-contact 150_2.

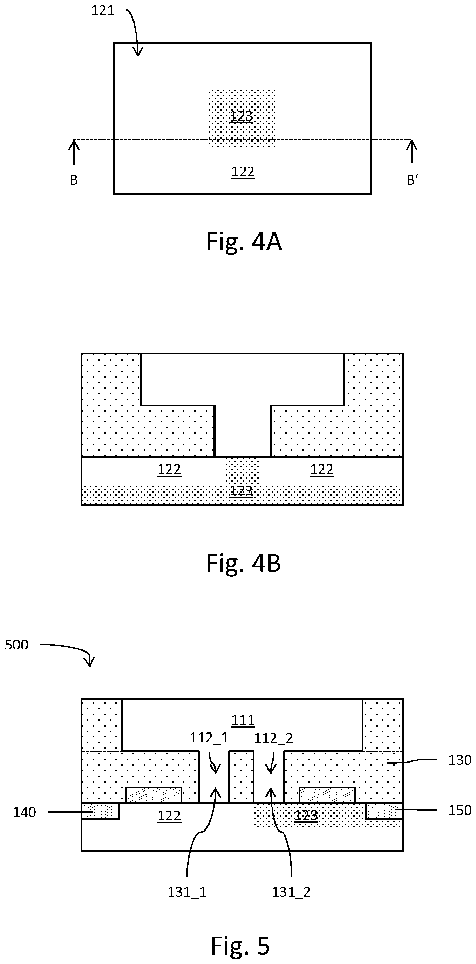

Figures 4A and 4B show a further exemplary arrangement of the n-doped region 122 and the p-doped region 123 within the photocurrent collecting structure 120. Fig. 4A shows a top view similar to Fig. 3 and Fig. 4B shows a cross section along the line B-B'. The n-contacts 140, p-contacts 150 and demodulation gates 170-173 are not shown in Figs. 4A and 4B but may for example be arranged as described with respect to Fig. 3.

As shown in Fig. 4A, the p-doped region 123 may be laterally surrounded by the n-doped region 122 at the upper surface 121 of the photocurrent collecting structure 120. According to another example, the arrangement of the n-doped region 122 and p-doped region 123 is reversed.

As shown in Fig. 4B, both the n-doped region 122 and the p-doped region 123 are in contact with the trunk portion 112 of the photosensitive structure 110. The p-doped region 123 may laterally extend out of the central area below the n-doped region 122 towards at least one p-contact 150 (not shown).

According to an example, half of the surface area of the photocurrent collecting structure 120 within a circumference of the trunk portion 112 of the photosensitive structure 110 is comprised of the n-doped region 122 and the other half is comprised of the p-doped region 123. According to another example, the ratio of the surface areas may be different, for example about 60:40 or 70:30 or 40:60 or 30:70.

Figure 5 shows a further exemplary pixel 500 of a time of flight sensor which may be similar to or identical with the pixel 100 or 200, except for the differences described in the following.

In particular, the photosensitive structure 110 of the pixel 500 does not comprise a single trunk portion 112 but it instead comprises at least two trunk portions 112_1 and 112_2. The at least two trunk portions 112_1, 112_2 may be laterally separated by part of the dielectric material layer 130. The two trunk portions 112_1, 112_2 are both contiguous with the upper portion 111 of the photosensitive structure 110.

The first trunk portion 112_1 is in contact with the n-doped region 122 of the photocurrent collecting structure 120 (but not with the p-doped region 123) and the second trunk portion 112_2 is in contact with the p-doped region 123 (but not with the n-doped region 122). Therefore, in the pixel 500 electrons of the photocurrent are conducted towards the at least one n-contact 140 through the first trunk portion 112_1 and holes of the photocurrent are conducted towards the at least one p-contact 150 through the second trunk portion 112_2. In the pixels 100 and 200 on the other hand, both types of charge carrier are conducted through the single trunk portion 112.

Fabricating the pixel 500 may comprise providing a first aperture 131_1 and a second aperture 131_2 in the dielectric material layer 130 and epitaxially growing the photosensitive structure 110 out of both apertures 131_1, 131_2. The epitaxial growth parameters may have to be monitored in order to prevent lattice dislocations when the two growth structures fuse during formation of the upper portion 111.

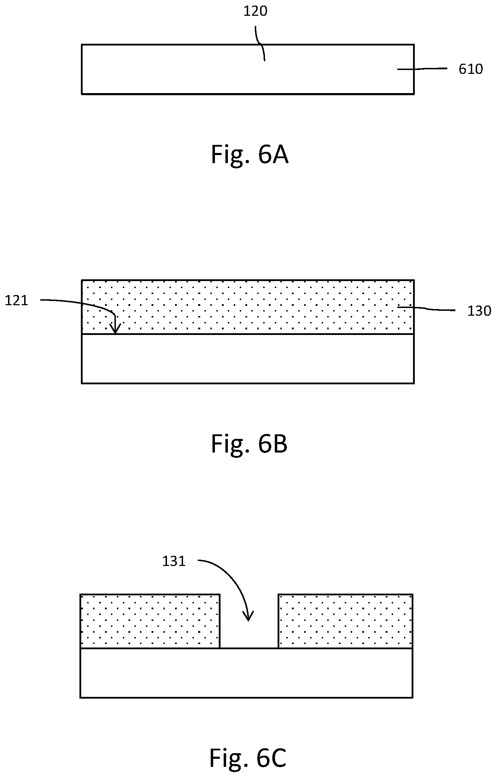

Figures 6A to 6E show the pixel 200 in various stages of fabrication according to an exemplary method for fabricating a time of flight sensor comprising at least one pixel. Similar methods may be used to fabricate a time of flight sensor comprising at least one pixel 100 or 500.

As shown in Figure 6A, a Si substrate 610, e.g. a Si wafer or a Si die, is provided. The Si substrate 610 comprises the photocurrent collecting structure 120 which may e.g. be provided in an epitaxial layer of the Si substrate 610. According to an example, a plurality of photocurrent collecting structures 120 are provided in the Si substrate 610 such that an array of pixels 200 of the time of flight sensor may be fabricated on the Si substrate 610. According to another example, a single photocurrent collecting structure 120 is provided.

As shown in Figure 6B, the dielectric material layer 130 is fabricated on the photocurrent collecting structure 120. The dielectric material layer 130 may for example be an oxide layer. The dielectric material layer 130 may completely cover the upper surface 121 of the photocurrent collecting structure 120.

As shown in Figure 6C, the aperture 131 within the dielectric material layer 130 is fabricated. This may for example be done using drilling, e.g. laser drilling, or by using photolithographic structuring.

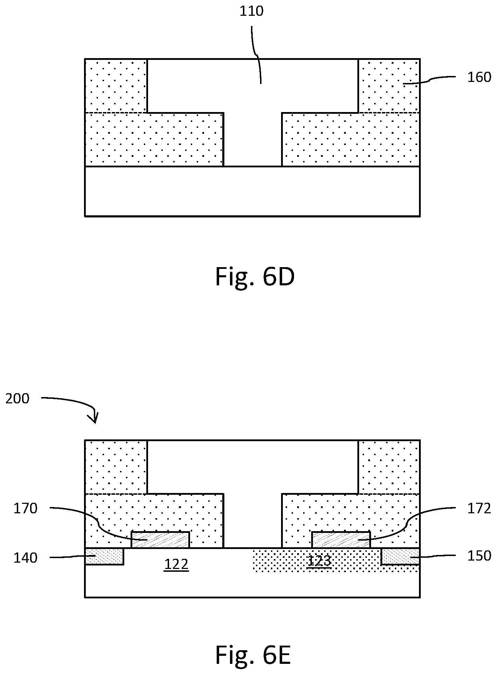

As shown in Figure 6D, the photosensitive structure 110 is epitaxially grown on the photocurrent collecting structure 120, starting in the aperture 131. According to an example, the aperture 131 has a high enough aspect ratio such that aspect ratio trapping can be used to essentially keep the upper portion 111 of the photosensitive structure 110 free of lattice dislocations.

As also shown in Figure 6D, fabricating a time of flight sensor comprising the pixel 200 may optionally comprise providing the further dielectric material layer 160. According to an example, the further dielectric material layer 160 is fabricated prior to epitaxially growing the photosensitive structure 110. According to another example, the further dielectric material layer 160 is fabricated after the photosensitive structure 110 has been fabricated.

As shown in Figure 6E, the at least one n-contact 140 and the at least one p-contact 150 are fabricated in the photocurrent collecting structure 120. This may comprise providing a suitable metallization on the photocurrent collecting structure 120. According to an example, the n-contact 140 and p-contact 150 are fabricated after the photosensitive structure 110 has been fabricated, as shown in the example of Fig. 6E. However, it is also possible that the contacts are fabricated at an earlier stage of the fabrication process, e.g. after the stage shown in Fig. 6A or 6B.

Fabricating the pixel 200 may further comprise providing the demodulation gates 170, 172 and the n-doped region 122 and the p-doped region 123 of the photocurrent collecting structure 120. Doping may also be performed on the photosensitive structure 110, for example p-doping. According to an example, n-doping may be done using P, Sb or As atoms and p-doping may be done using B, A1 or Ga atoms. Providing the demodulation gates 170, 172 may also be done at an earlier stage of fabrication, as mentioned above with respect to the contacts 140, 150.

According to an example, fabricating the time of flight sensor comprising the at least one pixel 200 also comprises fabricating evaluation circuitry, wherein the evaluation circuitry is configured to use both electrons and holes of the photocurrent collected by the at least one n-contact 140 and the at least one p-contact 150 to measure a signal. The evaluation circuitry may e.g. be provided in the Si substrate 610. Furthermore, a protective layer may be fabricated on the upper surface 113 of the photosensitive structure 110. Fabricating the time of flight sensor may also comprise fabricating a light emitter, e.g. a diode, which may for example be arranged on the substrate 610 or it may be arranged on a separate substrate.

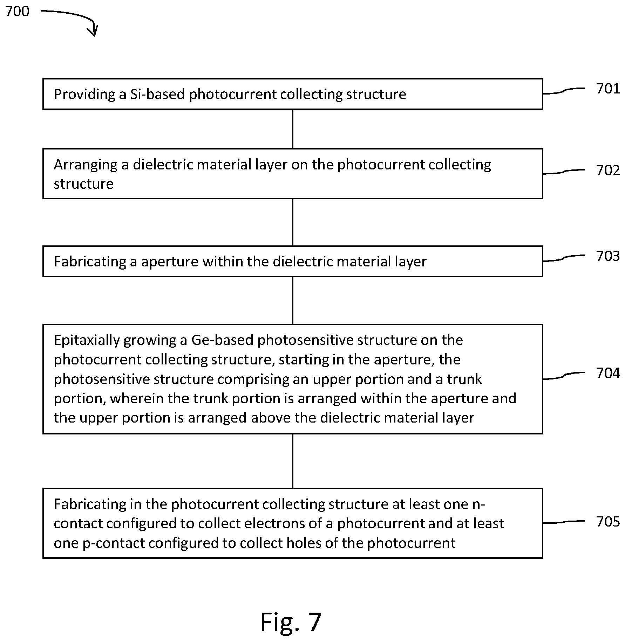

Figure 7 is a flow chart of a method 700 for fabricating a time of flight sensor comprising at least one pixel. The method 700 may for example be used to fabricate a time of flight sensor comprising at least one of the pixels 100, 200 or 500.

The method 700 comprises at 701 an act of providing a Si-based photocurrent collecting structure, at 702 an act of arranging a dielectric material layer on the photocurrent collecting structure, at 703 an act of fabricating a aperture within the dielectric material layer, at 704 an act of epitaxially growing a Ge-based photosensitive structure on the photocurrent collecting structure, starting in the aperture, the photosensitive structure comprising an upper portion and a trunk portion, wherein the trunk portion is arranged within the aperture and the upper portion is arranged above the dielectric material layer, and at 705 an act of fabricating in the photocurrent collecting structure at least one n-contact configured to collect electrons of a photocurrent and at least one p-contact configured to collect holes of the photocurrent.

### EXAMPLES

In the following, the time of flight sensor and the method for fabricating a time of flight sensor are further explained using specific examples.

Example 1 is a time of flight sensor, comprising: at least one pixel, comprising: an epitaxially-grown Ge-based photosensitive structure comprising an upper portion and a trunk portion, a Si-based photocurrent collecting structure, a dielectric material layer arranged at least between the upper portion of the photosensitive structure and the photocurrent collecting structure, wherein the trunk portion of the photosensitive structure is arranged within an aperture in the dielectric material layer, and at least one n-contact configured to collect electrons of a photocurrent and at least one p-contact configured to collect holes of the photocurrent, the at least one n-contact and p-contact arranged in the photocurrent collecting structure.

Example 2 is the time of flight sensor of example 1, wherein the photosensitive structure of the at least one pixel comprises a single trunk portion in the form of said trunk portion.

Example 3 is the time of flight sensor of example 1, wherein the photosensitive structure comprises a second trunk portion arranged within a second aperture in the dielectric material layer.

Example 4 is the time of flight sensor of example 1 or 2, wherein a p-n junction within the photocurrent collecting structure is arranged vertically below the trunk portion of the photosensitive structure.

Example 5 is the time of flight sensor of one of the preceding examples, wherein the at least one pixel comprises a first and a second n-contact and a first and a second demodulation gate, the first and second demodulation gates configured to direct electrons of the photocurrent to either the first or the second n-contact.

Example 6 is the time of flight sensor of one of the preceding examples, wherein the at least one pixel comprises a first and a second p-contact and a third and a fourth demodulation gate, the third and fourth demodulation gates configured to direct holes of the photocurrent to either the first or the second p-contact.

Example 7 is the time of flight sensor of one of the preceding examples, wherein the photocurrent collecting structure includes an n-doped region configured to conduct electrons of the photocurrent to the at least one n-contact and a p-doped region configured to conduct holes of the photocurrent to the at least one p-contact, wherein the n-doped region and the p-doped region are both in contact with the photosensitive structure.

Example 8 is the time of flight sensor of example 7, wherein the n-doped region and the p-doped region are laterally juxtaposed.

Example 9 is the time of flight sensor of example 7, wherein one of the n-doped region and the p-doped region laterally surrounds the other of the n-doped region and the p-doped region.

Example 10 is the time of flight sensor of one of the preceding examples, wherein the trunk portion has an aspect ratio in the range of 1:1 to 1:10.

Example 11 is a method for fabricating a time of flight sensor comprising at least one pixel, the method comprising: providing a Si-based photocurrent collecting structure, arranging a dielectric material layer on the photocurrent collecting structure, fabricating a aperture within the dielectric material layer, epitaxially growing a Ge-based photosensitive structure on the photocurrent collecting structure, starting in the aperture, the photosensitive structure comprising an upper portion and a trunk portion, wherein the trunk portion is arranged within the aperture and the upper portion is arranged above the dielectric material layer, and fabricating in the photocurrent collecting structure at least one n-contact configured to collect electrons of a photocurrent and at least one p-contact configured to collect holes of the photocurrent.

Example 12 is the method of example 11, further comprising: doping a first portion of the photocurrent collecting structure to fabricate an n-doped region configured to conduct electrons of the photocurrent to the at least one n-contact, and doping a second portion of the photocurrent collecting structure to fabricate a p-doped region configured to conduct holes of the photocurrent to the at least one p-contact.

Example 13 is the method of example 11 or 12, further comprising: fabricating a first n-contact and a second n-contact in the photocurrent collecting structure, and fabricating a first and a second demodulation gate over the photocurrent collecting structure, the first and second demodulation gates configured to direct electrons of a photocurrent to either the first or the second n-contact.

Example 14 is the method of one of examples 11 to 13, further comprising: fabricating a first p-contact and a second p-contact in the photocurrent collecting structure, and fabricating a third and a fourth demodulation gate over the photocurrent collecting structure, the third and fourth demodulation gates configured to direct holes of a photocurrent to either the first or the second p-contact.

Example 15 is the method of one of examples 11 to 14, further comprising: providing evaluation circuitry configured to use both electrons and holes of a photocurrent collected by the at least one n-contact and the at least one p-contact to measure a signal.

Example 16 is an apparatus comprising means for performing the method according to anyone of examples 11 to 15.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. A time of flight sensor, comprising:
at least one pixel, comprising:
an epitaxially-grown Ge-based photosensitive structure comprising an upper portion and a trunk portion,
a Si-based photocurrent collecting structure,
a dielectric material layer arranged at least between the upper portion of the photosensitive structure and the photocurrent collecting structure, wherein the trunk portion of the photosensitive structure is arranged within an aperture in the dielectric material layer, and
at least one n-contact configured to collect electrons of a photocurrent and at least one p-contact configured to collect holes of the photocurrent, the at least one n-contact and p-contact arranged in the photocurrent collecting structure.

2. The time of flight sensor of claim 1, wherein the photosensitive structure of the at least one pixel comprises a single trunk portion in the form of said trunk portion.

3. The time of flight sensor of claim 1, wherein the photosensitive structure comprises a second trunk portion arranged within a second aperture in the dielectric material layer.

4. The time of flight sensor of claim 1 or 2, wherein a p-n junction within the photocurrent collecting structure is arranged vertically below the trunk portion of the photosensitive structure.

5. The time of flight sensor of one of the preceding claims, wherein the at least one pixel comprises a first and a second n-contact and a first and a second demodulation gate, the first and second demodulation gates configured to direct electrons of the photocurrent to either the first or the second n-contact.

6. The time of flight sensor of one of the preceding claims, wherein the at least one pixel comprises a first and a second p-contact and a third and a fourth demodulation gate, the third and fourth demodulation gates configured to direct holes of the photocurrent to either the first or the second p-contact.

7. The time of flight sensor of one of the preceding claims, wherein the photocurrent collecting structure includes an n-doped region configured to conduct electrons of the photocurrent to the at least one n-contact and a p-doped region configured to conduct holes of the photocurrent to the at least one p-contact, wherein the n-doped region and the p-doped region are both in contact with the photosensitive structure.

8. The time of flight sensor of claim 7, wherein the n-doped region and the p-doped region are laterally juxtaposed.

9. The time of flight sensor of claim 7, wherein one of the n-doped region and the p-doped region laterally surrounds the other of the n-doped region and the p-doped region.

10. The time of flight sensor of one of the preceding claims, wherein the trunk portion has an aspect ratio in the range of 1:1 to 1:10.

11. A method for fabricating a time of flight sensor comprising at least one pixel, the method comprising:
providing a Si-based photocurrent collecting structure,
arranging a dielectric material layer on the photocurrent collecting structure,
fabricating a aperture within the dielectric material layer,
epitaxially growing a Ge-based photosensitive structure on the photocurrent collecting structure, starting in the aperture, the photosensitive structure comprising an upper portion and a trunk portion, wherein the trunk portion is arranged within the aperture and the upper portion is arranged above the dielectric material layer, and
fabricating in the photocurrent collecting structure at least one n-contact configured to collect electrons of a photocurrent and at least one p-contact configured to collect holes of the photocurrent.

12. The method of claim 11, further comprising:
doping a first portion of the photocurrent collecting structure to fabricate an n-doped region configured to conduct electrons of the photocurrent to the at least one n-contact, and
doping a second portion of the photocurrent collecting structure to fabricate a p-doped region configured to conduct holes of the photocurrent to the at least one p-contact.

13. The method of claim 11 or 12, further comprising:
fabricating a first n-contact and a second n-contact in the photocurrent collecting structure, and
fabricating a first and a second demodulation gate over the photocurrent collecting structure, the first and second demodulation gates configured to direct electrons of a photocurrent to either the first or the second n-contact.

14. The method of one of claims 11 to 13, further comprising:
fabricating a first p-contact and a second p-contact in the photocurrent collecting structure, and
fabricating a third and a fourth demodulation gate over the photocurrent collecting structure, the third and fourth demodulation gates configured to direct holes of a photocurrent to either the first or the second p-contact.

15. The method of one of claims 11 to 14, further comprising:
providing evaluation circuitry configured to use both electrons and holes of a photocurrent collected by the at least one n-contact and the at least one p-contact to measure a signal.
